# EUROPÄISCHE PATENTSCHRIFT

(11) **EP 3 093 679 B1**
(45) Veröffentlichungstag und Bekanntmachung des Hinweises auf die Patenterteilung: **25.10.2017**
(21) Anmeldenummer: 16169076.3
(22) Anmeldetag: 11.05.2016
(51) Int. Cl.: G01R 33/30

(54) **MAS-STATOR MIT ABSAUGVORRICHTUNG**
MAS STATOR WITH SUCTION DEVICE
STATOR POUR RAM AVEC DISPOSITIF D'ASPIRATION

(30) Priorität: 13.05.2015 DE 102015208850
(43) Veröffentlichungstag der Anmeldung: 16.11.2016
(73) Patentinhaber: Bruker BioSpin GmbH, 76287 Rheinstetten (DE)
(72) Erfinder: Osen, David, 76275 Ettlingen (DE); Knott, Benno, 76189 Karlsruhe (DE); Purea, Armin, 76669 Bad Schönborn (DE)
(74) Vertreter: Kohler Schmid Möbus Patentanwälte

(56) Entgegenhaltungen:
- EP-A2- 0 089 097
- DE-T5-112005 002 582
- US-A1- 2010 026 302

## Beschreibung

Die Erfindung betrifft einen MAS-Stator für einen Kernspinresonanz(=NMR)-Magic-Angle-Spinning(=MAS)-Probenkopf, wobei der MAS-Stator ein Bodenlager mit mindestens einer Düse sowie mindestens ein, insbesondere genau zwei Radiallager aufweist, und ein im Wesentlichen kreiszylindrischer MAS-Rotor zur Aufnahme einer Messsubstanz vorgesehen ist, welcher in einer Messposition innerhalb des MAS-Stators mittels einer Einrichtung zur Gaszufuhr druckgasgelagert sowie mittels eines pneumatischen Antriebs in Rotation um die Zylinderachse des MAS-Rotors versetzt werden kann, wobei der MAS-Stator mit einem Absaugrohr ausgestattet ist. Ein solcher NMR-MAS-Probenkopf ist bekannt aus DE 10 2013 201 110 B3.

Kernspinresonanz(=NMR)-Spektroskopie ist ein Verfahren der instrumentellen Analytik, mit dem insbesondere die chemische Zusammensetzung von Messproben bestimmt werden kann. Dabei werden Hochfrequenz(=HF)-Pulse in die Messprobe, die sich in einem starken statischen Magnetfeld befindet, eingestrahlt, und die elektromagnetische Reaktion der Probe wird vermessen.

Bei der Festkörper NMR-Spektroskopie ist es bekannt zur Verringerung von Linienverbreiterungen aufgrund anisotroper Wechselwirkungen, eine NMR-Probe während der spektroskopischen Vermessung unter dem so genannten "Magischen Winkel" von ca. 54,74° gegenüber dem statischen Magnetfeld verkippt rotieren zu lassen ("MAS" = Magic Angle Spinning). Dazu wird die Probe in einen MAS-Rotor gefüllt. MAS-Rotoren sind zylindrische Röhrchen, die mit einer oder zwei Kappen verschlossen sind, wobei die obere mit Flügelelementen (« Schaufelrädchen ») versehen ist.

Es gibt zwei Varianten von Rotoren:
1. Der Rotor hat ein Sackloch. Die offene Seite wird mit besagter Kappe verschlossen.
2. Der Rotor besitzt ein Durchgangsloch. Dies sind primär die sogenannten « kleinen Systeme ». Hier gibt es oben die bereits genannte Kappe und zusätzlich für unten eine Kappe mit einem ebenen Boden (zumindest bei den Rotoren der Anmelderin, also von Firmen der Bruker-Gruppe).

Der MAS-Rotor wird in einem MAS-Stator angeordnet, und mit Gasdruck wird der MAS-Rotor über die Flügelelemente für die Rotation angetrieben. Die Gesamtheit aus MAS-Rotor und MAS-Stator wird MAS-Turbine genannt.

Während der NMR-Messung ist die MAS-Turbine in einem NMR-MAS-Probenkopf angeordnet. Der Probenkopf verfügt über ein zylindrisches Abschirmrohr (auch kurz "Rohr" genannt) und in der Regel über einen Fußkasten. Im Rohr sind Hochfrequenz(=HF)-Elektronik-Bauteile, insbesondere HF-Resonatorspulen, und die MAS-Turbine untergebracht, wobei die MAS-Turbine im Bereich des vom Fußkasten abgewandten Endes des Rohres angeordnet ist. Der Probenkopf wird mit seinem Abschirmrohr typischerweise von unten in die vertikale Raumtemperaturbohrung eines supraleitenden Magneten eingeführt, positioniert, und mit Haken, Stützen, Schrauben oder dergleichen gehalten. Die MAS-Turbine befindet sich dann genau im magnetischen Zentrum des Magneten.

Um eine NMR-Probe bzw. einen mit Messsubstanz gefüllten MAS-Rotor auszutauschen, ist es bei einfachen Probenköpfen notwendig, den Probenkopf aus dem Magneten auszubauen, d.h. den Probenkopf aus der Raumtemperaturbohrung herauszunehmen. Dazu kniet der Anwender unter dem Magneten, löst die Halterungen und Kabelverbindungen, und fängt den Probenkopf auf, wenn dieser aus dem Magneten gleitet. Durch in den Metallteilen des Probenkopfs, insbesondere im Abschirmrohr, induzierte Wirbelströme und das Eigengewicht des Probenkopfs kann ein Herausziehen des Probenkopfs oder auch ein Wiedereinführen in den Magneten mit erheblicher Kraftanstrengung verbunden sein. Die Hersteller von Probenköpfen schreiben vor, den Probenkopfausbau sicherheitshalber durch zwei Personen gemeinsam vorzunehmen. Am ausgebauten Probenkopf kann dann der Rotor manuell gewechselt werden. Meist ist nach einem Rotorwechsel - und damit der Neupositionierung des Probenkopfs im Magneten - ein erneutes Shimmen erforderlich, so dass dieses Vorgehen insgesamt recht aufwändig ist.

Aus der DE 38 18 039 A1 ist es bekannt, in unmittelbarer Nähe des MAS-Stators am Probenkopf ein drehbares Probenmagazin vorzusehen, so dass die Probe im MAS-Stator mehrmals durch Gasdruckbetätigung getauscht werden kann, ohne den Probenkopf oder das Probenmagazin aus dem Inneren des Magneten zu entfernen.

Aus dem technischen Poster von Shevgoor et al. "Development of a CryoMAS™ HR-MAS-MAG NMR Probe for High-field WB Magnets", Sid Shevgoor et al., Doty Scientific, Columbia, SC, USA, präsentiert auf der ENC 2005, Providence, Rhode Island, USA, im Internet zugänglich am 9.10.2008 unter http://www.dotynmr.com/PDF/CryoMAS ENC05.pdf, ist der Einsatz eines Liftsystems für MAS-Rotoren bekannt geworden. An dem dem Fußkasten abgewandten Ende des Rohres eines Probenkopfs wird eine Transportleitung angeschlossen, die durch die Raumtemperaturbohrung eines Magneten nach oben aus dem Magneten führt. Durch die Transportleitung kann mittels Gasdruck ein MAS-Rotor in den MAS-Stator des im Magneten montierten Probenkopfs gefördert werden, und auch ein MAS-Rotor aus dem MAS-Stator nach oben aus dem Probenkopf heraus gefördert werden.

Um einen schnellen Wechsel zwischen verschiedenen MAS-Rotoren zu ermöglichen, bei dem darüber hinaus die HF-Abschirmung und die Einhaltung definierter, extremer Temperaturbedingungen erleichtert ist, wird in der DE 10 2008 054 152 B3 ein Probenkopf mit einem Fußkasten und einem am Fußkasten befestigten und von diesem abstehenden Rohr vorgeschlagen, wobei im Bereich des dem Fußkasten abgewandten Endes des Rohres innerhalb des Rohres der MAS-Stator zur Aufnahme eines MAS-Rotors angeordnet ist, und wobei eine Transportleitung zum pneumatischen Überführen eines MAS-Rotors innerhalb der Transportleitung, die im Inneren des Rohres vom Fußkasten zum MAS-Stator verläuft, vorgesehen ist. Allerdings weist bei dieser bekannten Anordnung das Frontlager nicht wie bei einem gattungsbildenden Probenkopf der eingangs definierten Art eine mittels einer Verschlussvorrichtung verschließbare Öffnung zur Einführung eines MAS-Rotors in den Raum zwischen Bodenlager und Frontlager auf, so dass damit ein Rotorwechsel im verschlossenen Probenkopf nicht möglich ist.

Insbesondere bei MAS-Rotoren mit Durchmessern ≤ 1,9mm ist ein Verschluss an beiden Seiten zur Stabilisierung der Rotation erforderlich.

Zur Automatisierung des Rotorwechsels wird in der eingangs zitierten DE 10 2013 201 110 B3 vorgeschlagen, eine Transportleitung zum Überführen eines MAS-Rotors NMR-MAS-Probenkopf bereitzustellen, mit dem der Rotor in den Stator überführt werden kann. Wie in DE 10 2013 201 110 B3 weiterhin offenbart ist, umfasst der Stator einen zusätzlichen Verschluss an der Kopfseite des Rotors, um die Rotation zu stabilisieren. Insbesondere bei MAS Rotoren mit einem Durchmesser von weniger als 2,5mm ist mit Problemen zu rechnen, da die Bernoulli Kraft des Bodenlagers nicht ausreicht, jedenfalls nicht ausreichend zuverlässig, um den Rotor in Position zu halten.

Die DE 11 2005 002 582 T5 offenbart ein axiales Bernoulli-Gaslager für einen durch Gas angetriebenen NMR MAS Probenrotor (Probendrehteil), bei dem ein Zustrom mit niedriger Rotationskomponente nach innen über ein konisch geformtes Rotorende strömt. Zwischen diesem und einer konischen Stator-Lagerfläche ist ein konischer Durchströmungsbereich gebildet. Der hier vorgestellte Stator ist insbesondere für die automatisierten Rotorwechsel geeignet. Es wird in der DE 11 2005 002 582 T5 nicht beschrieben, ob sie besonders geeignet ist für Rotoren mit kleinen Durchmessern. Auch ist eine Gasableitung vom Bernoulli Lager weg nicht offenbart.

In US 7,915,893 B2 wird ein Stator für eine CryoMAS Probe offenbart, bei dem die Messspulen mittels eines gekühlten He-Fingers temperiert werden. Die Messprobe hingegen kann bei einer Temperatur um den Raumtemperaturbereich vermessen werden. Da der Antrieb auch hier pneumatisch erfolgt, wird der Spinner hermetisch verschlossen, damit die Gaszufuhr für Antrieb und Lager nicht in den gekühlten Bereich der Messelektronik gelangt. Um das zu verhindern, wird das in den Stator eingeblasene Gas durch ein Abgassystem wieder abgeführt. Die Gasabfuhr kann zur Optimierung des Drehverhaltens der Messprobe bei Drücken von 0,5-2bar angepasst werden (siehe Spalte 6, Zeilen 32-37). Hier wird allerdings nicht beschrieben, ob und gegebenenfalls wodurch das System geeignet wäre für Rotoren, die einen sehr kleinen Durchmesser von weniger als 3mm haben. Hier ist auch die Rede von Drehzahlen zwischen 2 bis 8kHz bzw. 300Hz bis 30kHz, was auf die "großen" Systeme schließen lässt. In der Praxis werden die kleineren Rotoren bei höheren Frequenzen rotiert, wobei der begrenzende Faktor die Schallgeschwindigkeit an der Rotoraußenfläche ist. Konkret wird der 2,5mm-Rotor bei ca. 35kHz, der 1,9mm-Rotor bei ca. 42kHz und der 1,3mm-Rotor bei 67kHz betrieben

Typischerweise wird der MAS-Rotor während der NMR-Messung gasgelagert in dem Stator gehalten, um die Reibungsverluste zu reduzieren und damit die hohen Drehgeschwindigkeiten erzielen zu können. Dazu dienen mindestens ein Radiallager und ein als Axiallager ausgestaltetes Bodenlager. Letzteres erzeugt durch hohe Gasgeschwindigkeit in radialer Richtung einen hohen dynamischen Druck mit gleichzeitiger Absenkung des statischen Drucks, was eine Kraft in axialer Richtung erzeugt, nämlich die Bernoulli-Kraft, die den Rotor im Stator hält und ihn auf einem Luftkissen schweben lässt. Dies trifft in der Praxis aber nur bei MAS-Rotoren mit einem Durchmesser größer als 2,5mm zu. Theoretisch trifft es eigentlich auf alle MAS-Systeme zu. Bei den kleinen Systemen funktioniert dies jedoch nicht beziehungsweise nicht zuverlässig. Dies liegt vermutlich, an der geringen Masse der Rotoren und an der geringen Haltekraft aufgrund der geringen Fläche des Bodenlagers, so dass ein Gegenlager als Verschluss benötigt wird.

In der eingangs zitierten DE 10 2013 201 110 B3 wurde die Problematik dadurch gelöst, dass ein Verschluss bereitgestellt wurde, der über eine Schiebermechanik bedienbar ist. Allerdings ist diese Lösung, insbesondere für gekühlte Proben aufgrund der Materialeigenschaften beim Temperaturwechsel, nur bedingt geeignet und zudem recht anspruchsvoll in der Ausführung und bezüglich der Einstellung. Auch benötigt diese Anordnung recht viel Platz, der insbesondere bei SB ("Standard Bore") nur sehr begrenzt vorhanden ist. Auch ist sie beim Flippen in die Senkrechte hinderlich.

### Aufgabe der Erfindung

Der vorliegenden Erfindung liegt demgegenüber die Aufgabe zugrunde, einen NMR-MAS-Probenkopf der eingangs definierten Art mit stabilisierter Rotation zur Verfügung zu stellen, der ohne die genannten Verschlussmittel auskommt. Das System soll automatisierbar sein, d.h. einen Messprobenaustausch erlauben, ohne dass ein mechanischer Verschluss am Kopfende des Stators erforderlich ist/ohne dass der Kopf aus dem Magneten heraus genommen werden muss.

### Kurze Beschreibung der Erfindung

Diese Aufgabe wird gelöst durch einen MAS-Stator der eingangs genannten Art, der dadurch gekennzeichnet ist, dass der MAS-Stator eine Absaugvorrichtung enthält, welche das Absaugrohr umfasst, und welche zur Absaugung des von der Einrichtung zur Gaszufuhr eingebrachten Gases derart eingerichtet ist, dass sie in einem Raum unterhalb des Radiallagers im Messbetrieb einen Unterdruck gegenüber der den MAS-Stator umgebenden Atmosphäre erzeugt, so dass der Gasstrom des Bodenlagers angesaugt wird und eine grössere Haltekraft im Bodenlager resultiert als im Falle ausschliesslicher Nutzung des Bernoulli-Effekts, und dass der MAS-Stator zur Aufnahme eines MAS-Rotors mit einem Durchmesser von 0,2 mm bis 2,5 mm ausgelegt ist. Mit der vorliegenden Erfindung wird ein Stator für die NMR-MAS-Spektroskopie bereitgestellt, der am Kopfende des Stators keinen Verschluss aufweist, und somit kann der Stator unkompliziert und leicht automatisierbar mit dem Rotor beschickt werden.

Durch das Absaugen des eingedüsten Gasstroms steigt die zum Bodenlager gerichtete axiale Kraft auf den Rotor. Der technische Effekt, der sich durch die Absaugvorrichtung ergibt, besteht unter anderem darin, dass sich die Rotationseigenschaften der Rotoren deutlich verbessern. Insbesondere kleinere Rotoren (2,5mm, 1,9mm, 1,3mm, 0,7mm bis hinunter zu 0,2mm) können somit dauerhaft ohne Verschluss betrieben werden, ohne dass diese sich in Axialrichtung bewegen, was im Extremfall zum Auswurf der Rotoren führt, eben weil kein Verschluss am Kopfende vorhanden ist.

Ein Probenwechsel ist damit ohne ein Entfernen des Verschlusses möglich.

In der Theorie sollte die Haltekraft durch den Bernoulli-Effekt am axialen Bodenlager auch bei kleinen Rotoren ausreichen. In der Praxis spielen aber dynamische Effekte eine Rolle, wie z.B. Unwuchten, transiente Vorgänge beim Hochfahren oder Störfrequenzen. Diese Effekte wirken sich auf den Abstand des Rotors vom Bodenlager aus. Die Störeffekte werden bei größeren Rotoren durch die größere Masse der Rotoren kompensiert, d.h. sie kommen leichter in das Kräftegleichgewicht des Lagers.

### Bevorzugte Ausführungsformen der Erfindung

Der Rotor wird mittels mindestens eines Radiallagers zentriert. Das Radiallager umfasst eine Mehrzahl von Gasdüsen, in der Regel 5 bis 8 Stück, die einen Gasstrom von außen in Radialrichtung auf den Rotor richten. Die Gasdüsen haben in der Regel einen Durchmesser von 150-300µm.

Weiterhin umfasst das System ein Bodenlager, das einen Gasstrom in Axialrichtung auf das planare Rotorende bzw. die in das Rotorende eingebrachte planare Bodenkappe richtet. Der Rotor wird somit daran gehindert, an der Bodenfläche aufzuliegen. Gleichzeitig bewirkt die Bernoulli-Kraft durch das nach außen abströmende Gas, dass der Rotor in Position gehalten wird.

Bei bevorzugten Ausführungsformen des erfindungsgemäßen Probenkopfs, bei welchen die Vorteile der vorliegenden Erfindung sich ganz besonders bemerkbar machen, ist der MAS-Stator zur Aufnahme eines MAS-Rotors mit einem Durchmesser von 0,7mm bis 1,9mm ausgelegt. MAS-Rotoren in diesem Größenbereich benötigten bisher zwingend einen Verschluss am Kopfende des MAS-Stators.
In der Praxis erweisen sich Ausführungsformen der Erfindung als besonders nützlich, bei welchen die Absaugvorrichtung eine Gasleitung zur Absaugung des von der Einrichtung zur Gaszufuhr eingebrachten Gases mit einem Querschnitt von 0,2mm² bis 100mm², vorzugsweise von 1,5mm² bis 10mm², aufweist. Dies ist in der Regel ausreichend für das Volumen des abgesaugten Gasstroms.
Des Weiteren ist bei bevorzugten Ausführungsformen des erfindungsgemäßen Probenkopfes die Absaugvorrichtung so ausgelegt, dass sie im Messbetrieb mit einem Unterdruck gegenüber der den MAS-Stator umgebenden Atmosphäre von -10⁴ Pa bis -10⁵ Pa (-0,1 bar bis -1 bar) beaufschlagbar ist. Vorzugsweise liegt der Unterduck bei -2 x 10⁴ Pa bis -4 x 10⁴ Pa (-0,2 bar bar bis -0,4 bar), wodurch zum Beispiel bei 1,3mm-Rotoren eine ausreichend hohe Haltekraft für stabilen Betrieb ohne ungewünschten Auswurf erzielt wird. Der Vorteil eines geringen Saugdrucks liegt in der geringen Leistung, die für den Betrieb der Absaugung notwendig ist. Bei größeren Rotoren ergibt sich immerhin noch ein besonders ruhiges und stabiles Rotationsverhalten. Bevorzugt sind auch Ausführungsformen der Erfindung, bei denen ein pneumatisches Probenwechselsystem mit einer Transportleitung zum Zuführen und Abführen eines MAS-Rotors zum MAS-Stator vorgesehen ist, welches ebenfalls zur Automatisierung der Messvorbereitungen beiträgt. Ein Vorteil der vorliegenden Erfindung besteht unter anderem darin, dass das Probenwechselsystem gemäß DE 10 2008 054 152 B3 in gleicher Weise auch für Rotoren mit einem Durchmesser von 0,2mm bis 2,5mm verwendet werden kann. Bisher war dies nur unter Einsatz einer Verschlussvorrichtung gemäß der eingangs zitierten DE 10 2013 201 110 B3 möglich.

Eine weitere bevorzugte Ausführungsform, sieht vor, dass der Probenkopf im Bereich des Rohres als Dewar-Gefäß ausgebildet ist. Das Rohr ist also doppelwandig, mit einem zwischen den Wänden liegenden Vakuum ausgebildet; dies erleichtert die Temperierung bzw. Kühlung der Messprobe im Probenkopf für die NMR-Messung. Aufgrund der geschlossenen Ausbildung gibt es keine unerwünschten Wärmeleitungsbrücken.

Bei einer Klasse von vorteilhaften Ausführungsformen des erfindungsgemäßen MAS-Stators weist die Düse im Bodenlager einen Innendurchmesser zwischen 25µm und 500µm, vorzugsweise zwischen 80µm und 200µm, auf.

Eine weitere Klasse von besonders einfach aufgebauten und kompakten Ausführungsformen der Erfindung zeichnet sich dadurch aus, dass die Einrichtung zur Gaszufuhr nur eine einzige Düse im Bodenlager umfasst, mit der im Betrieb sowohl die zur Gaszufuhr für die Druckgaslagerung als auch die Gaszufuhr für den pneumatischen Antrieb zur Rotation des MAS-Rotors gemeinsam erfolgt.

Bevorzugt sind auch Ausführungsformen des erfindungsgemäßen MAS-Stators, bei welchen eine weitere Vorrichtung zur Gaszufuhr zum MAS-Rotor vorgesehen ist, mit welcher die Messsubstanz im Messbetrieb auf einer vorgebbaren Betriebstemperatur gehalten werden kann.

Vorteilhaft ist weiterhin eine Ausführungsform, bei der der MAS-Stator zur Einstellung des MAS-Winkels drehbar gelagert ist. Durch die Drehbarkeit des Stators im Probenkopf kann bei begrenztem Raum das Ein- und Ausführen des MAS-Rotors weiter erleichtert werden; enge Kurven werden vermieden. Durch die Drehbarkeit des Stators kann zum Ein- und Ausschleusen der Winkel der Stator-Lagerachse gegenüber der Längserstreckungsrichtung des Rohres (die regelmäßig zumindest in guter Näherung der Richtung des statischen Magnetfelds im NMR-Magneten entspricht) verglichen mit dem magischen Winkel verkleinert werden.

In den Rahmen der vorliegenden Erfindung fällt auch ein Verfahren zum Betrieb eines Probenkopfes mit MAS-Stator der oben beschriebenen erfindungsgemäßen Art, welches sich dadurch auszeichnet, dass der MAS-Stator einen MAS-Rotor mit einem Durchmesser von 0,2 mm bis 2,5 mm aufweist, und dass nach Positionieren des MAS-Rotors im MAS-Stator zunächst die Absaugvorrichtung angefahren wird, bevor das Bodenlager mit Druckgas beschickt wird, sodass der MAS-Rotor im Stator verbleibt und vibrationsfreier rotieren kann, um eine ausreichend hohe Haltekraft für stabilen Betrieb ohne ungewünschten Auswurf zu erzielen. Besonders bevorzugt ist eine Variante dieses Verfahrens, bei der nach erfolgter NMR-Messung der MAS-Rotor mit der Messsubstanz aus seiner Messposition innerhalb des MAS-Stators entfernt wird, indem die Unterdruckerzeugung an der Absaugvorrichtung abgeschaltet wird, während jedoch die Einrichtung zur Gaszufuhr am Bodenlager mit Druckgas beschickt wird, so dass im Raum unterhalb des Radiallagers ein Überdruck aufgebaut wird, durch welchen der MAS-Rotor aus seiner Messposition herausgeworfen wird.

Die Vorteile der vorliegenden Erfindung kommen in besonders günstiger Weise zum Tragen, wenn bei den oben beschriebenen Verfahren ein MAS-Rotor mit einem Durchmesser von 0,7mm bis 1,9mm, verwendet wird.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1: eine schematische Querschnittsdarstellung einer Ausführungsform des erfindungsgemäßen NMR-MAS-Probenkopfs ohne MAS-Rotor;
- Fig. 2: wie Fig. 1, aber mit eingesetztem MAS-Rotor;
- Fig. 3: vergrößerte Detailansicht aus Fig. 2 im Bereich des Bodenlagers mit Düse;
- Fig. 4: eine schematische Querschnittsdarstellung eines NMR-MAS-Probenkopfs gemäß Stand der Technik mit einer Weicheneinrichtung mit Abzweigung;
- Fig. 5: eine vergrößerte Darstellung des freien Endes des Rohres des Probenkopfs von Fig. 4;
- Fig. 6: eine schematische Querschnittsdarstellung einer NMR-Apparatur gemäß Stand der Technik , mit von unten in die Raumtemperaturbohrung des Magneten eingeführtem, erfindungsgemäßen Probenkopf; und
- Fig. 7: einen Probenkopf nach dem Stand der Technik in schematischer Schnittansicht mit den eingangs definierten Merkmalen und von Hand auf- und abschraubbarem Frontlager zur Einbringung beziehungsweise Entnahme des Rotors.

Die Erfindung betrifft eine neuartige Ausgestaltung des Bodenlagers eines MAS-Stators für einen MAS-NMR-Probenkopf, bei welchem am Kopfende des MAS-Stators kein Verschluss mehr vorgesehen ist, so dass ein besonders einfacher Probenwechsel ermöglicht wird. Stattdessen wird der Raum unterhalb des Radiallagers mittels einer speziellen Vorrichtung abgesaugt.

Zunächst soll aber zum besseren Verständnis die bisher übliche Technik erläutert werden, die von der Erfindung nunmehr verbessert wird:

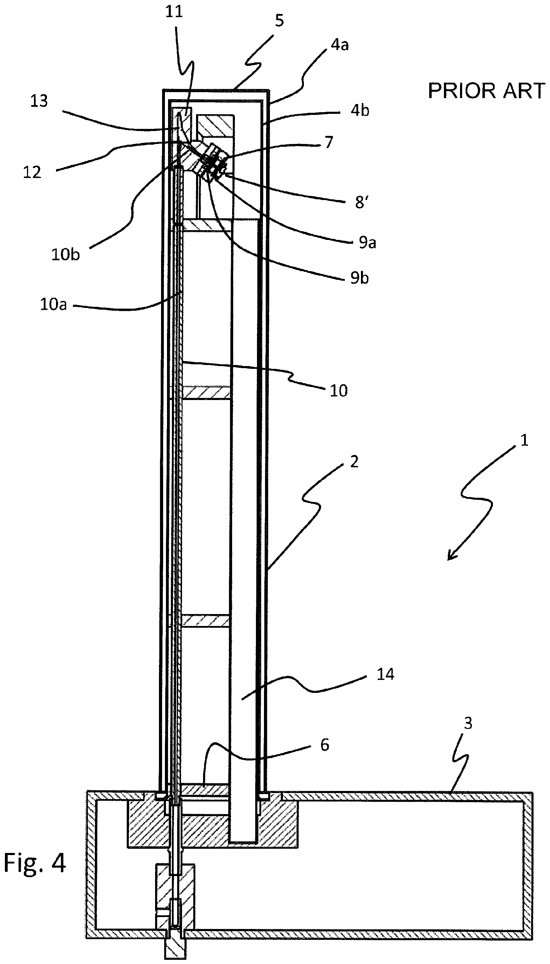

Die Figur 4 zeigt einen **NMR-MAS-Probenkopf 1** gemäß Stand der Technik in einer vertikalen Schnittebene. Der Probenkopf 1 umfasst im Wesentlichen ein **Rohr 2,** welches für eine NMR-Messung in die Raumtemperaturbohrung eines Magneten einzuführen ist, und einen **Fußkasten 3.** Auf dem Fußkasten 3 ist das Rohr 2 befestigt; das Rohr 2 steht vom Fußkasten 3 (hier) senkrecht ab. Der Fußkasten 3 bleibt außerhalb der Raumtemperaturbohrung des Magneten. Über den Fußkasten 3 wird der Probenkopf 1 typischerweise insgesamt gehalten oder befestigt, insbesondere am Magneten oder einem Unterbau des Magneten.

Das Rohr 2 weist hier eine doppelte Wandung (mit einer **äußeren Wand 4a** und einer **inneren Wand 4b**) auf, zwischen der ein Vakuum eingerichtet ist, so dass das Rohr 2 gleichzeitig als ein Dewar-Gefäß zur thermischen Isolation von der (in der Regel raumtemperaturwarmen) Umgebung ausgebildet ist. Im Rohr 2 können, soweit erforderlich, nicht näher dargestellte Temperierungsleitungen verlaufen, in denen (hier) ein Kühlmittel wie flüssiger Stickstoff zirkuliert, wodurch das Innere des Rohres 2 einschließlich Messprobe in einem MAS-Rotor und eine NMR-Messelektronik, insbesondere HF-Resonatoren in der Umgebung des MAS-Rotors, gekühlt werden. Alternativ (oder zusätzlich) können auch der Transportgasstrom in der **Transportleitung 10** und/oder andere Funktionsgasströme (siehe unten) gekühlt werden, wodurch (bei guter Isolation des Rohres 2) ebenfalls eine gute Kühlung im Inneren des Rohres 2 erreicht werden kann.

Zumindest eine Wand 4a, 4b des Rohres 2 ist aus einem elektrisch gut leitfähigen, aber nicht-ferromagnetischen Metall (etwa aus Kupfer) gefertigt. Die metallische Rohrwandung bewirkt eine Abschirmung des Rohrinnenraums gegen äußere elektromagnetische Wechselfelder; daher wird das Rohr 2 auch als Abschirmrohr bezeichnet.

Das Rohr 2 ist an seinem in Fig. 4 oberen, dem Fußkasten 3 abgewandten, **freien Ende 5** geschlossen ausgebildet, insbesondere sind keinerlei Durchführungen für Gas- oder Transportleitungen vorgesehen. Zugänge in das Rohrinnere, etwa für Elektro-, Gas- und Transportleitungen sind ausschließlich im Bereich des **fußkastennahen Endes 6** des Rohres 2 vorgesehen.

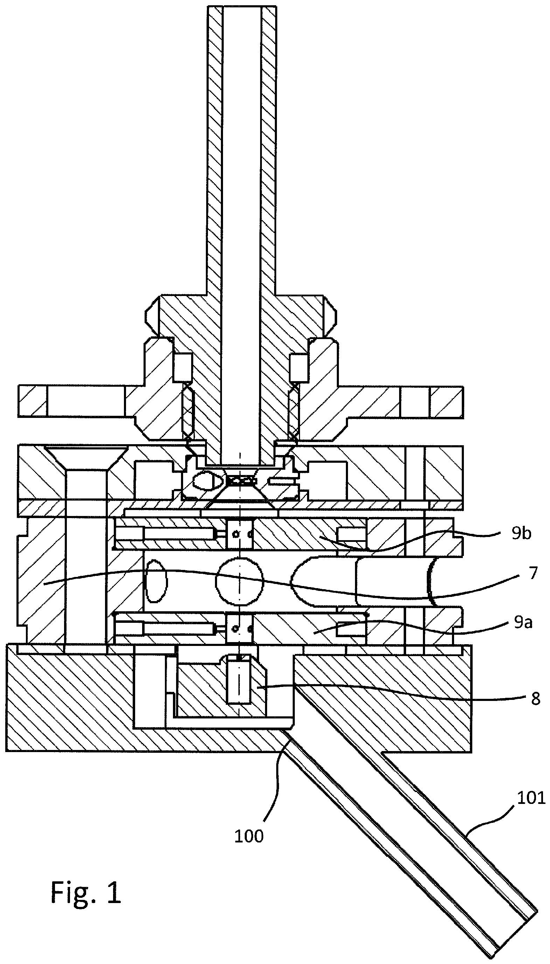

Das Rohr 2 enthält im Bereich seines freien Endes 5 einen **MAS-Stator 7.** Der Stator 7 kann einen MAS-Rotor (nicht dargestellt in den Figuren 1, 4 und 7) unter dem magischen Winkel (relativ zur Längserstreckung des Rohres 2, welches im Messbetrieb parallel dem statischen Magnetfeld ausgerichtet ist) halten und für eine Rotation um die Achse des Rotors lagern. Der Stator 7 verfügt stirnseitig über ein **Bodenlager 8,** an dem der Rotor im Stator 7 aufliegen kann (und somit entsprechend der Schwerkraft unten abgestützt wird); im Bodenlager 8 sind zwei (nicht näher dargestellte) Düsen für einen Lager-Gasstrom und einen Auswurf(=Eject)-Gasstrom ausgebildet. Der Stator 7 verfügt weiterhin über ein erstes, **unteres Radiallager 9a** nahe dem Bodenlager 8 sowie ein zweites, gegenüberliegendes, **oberes Radiallager 9b,** in denen jeweils eine Öffnung zur Durchführung des Rotors ausgebildet ist. Das Bodenlager 8 und das erste Radiallager 9a sind dem Fußkasten 3 zugewandt, und das zweite Radiallager 9b ist dem Fußkasten 3 abgewandt. In der Mitte zwischen erstem und zweitem Radiallager 9a, 9b liegt bei der NMR-Messung das magnetische Zentrum der Magnetanordnung. Der Stator 7 verfügt über nicht näher dargestellte Gasdüsen, mit denen ein eingeführter Rotor angeblasen und in Rotation versetzt werden kann.

Im Inneren des Rohres 2 verläuft weiterhin eine Transportleitung 10 für MAS-Rotoren. Ein **erster Abschnitt 10a** der Transportleitung 10 führt vom fußkastennahen Ende 6 des Rohres 2 vorbei am Stator 7 zu einer **Weicheneinrichtung 11.** Ein **zweiter Abschnitt 10b** der Transportleitung 10 führt von der Weicheneinrichtung 11 zum Stator 7. Die Weicheneinrichtung 11 umfasst einen **Sackbohrungsabschnitt 13** und eine **Verzweigung 12** der Transportleitung 10 (siehe dazu auch Fig. 4). Die Transportleitung 10 ist im Allgemeinen durch flexible Schläuche und/oder starre Rohre ausgebildet und kann, unter Berücksichtigung der Größe der MAS-Rotoren und des Spiels der Rotoren in der Transportleitung 10, neben geraden Abschnitten auch gekrümmte Abschnitte (Kurven) enthalten. Die Rotoren werden pneumatisch durch Gasdruck und/oder Schwerkraft in der Transportleitung 10 gefördert.

Im Inneren des Rohres 2 ist weiterhin ein robustes **Gestell 14** ausgebildet, auf dem der Stator 7 und diverse elektronische Komponenten (nicht gesondert dargestellt) für eine NMR-Messung an einer im Stator angeordneten Messprobe angeordnet sind. Der erste Abschnitt 10a der Transportleitung 10 ist hier als ein starres Rohr ausgebildet, wodurch das Gestell 14 eine verbesserte Stabilität erreicht. Einige elektronische Komponenten sind dabei am Abschnitt 10a unmittelbar befestigt (nicht gesondert dargestellt).

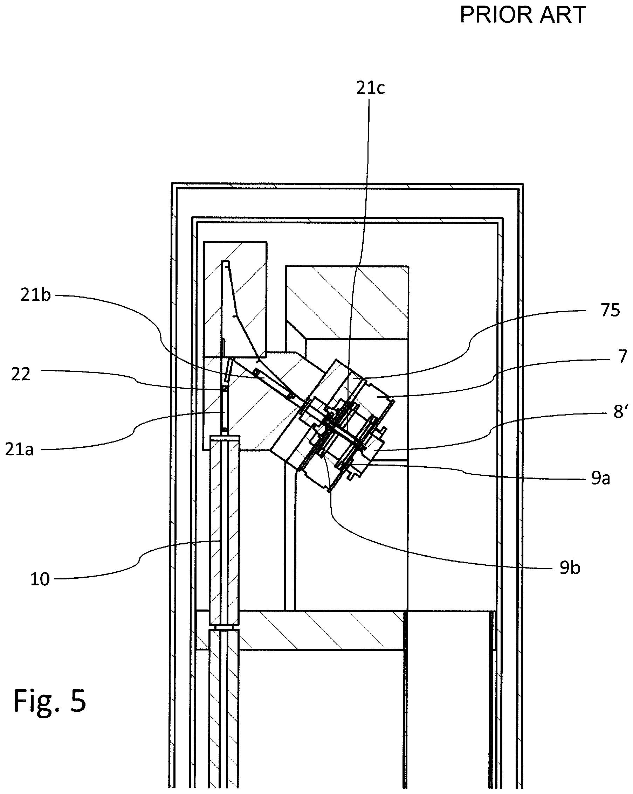

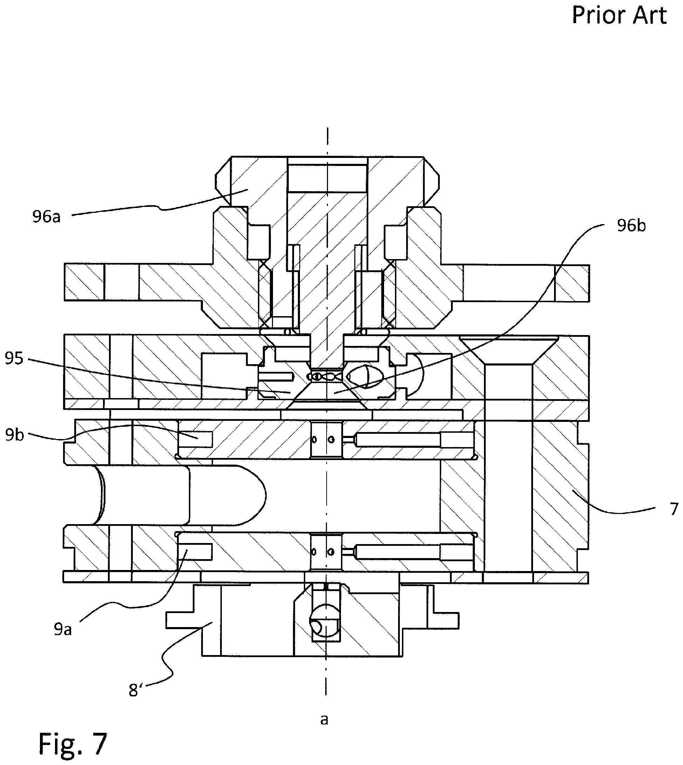

**Figur 5** veranschaulicht das Einführen eines **MAS-Rotors 21a, 21b, 21c** in den MAS-Stator 7 des Probenkopfs gemäß den Figuren 1 oder 7 im Detail. Die Darstellungen 21a, 21b, 21c des Rotors betreffen verschiedene Stadien beim Einführen.

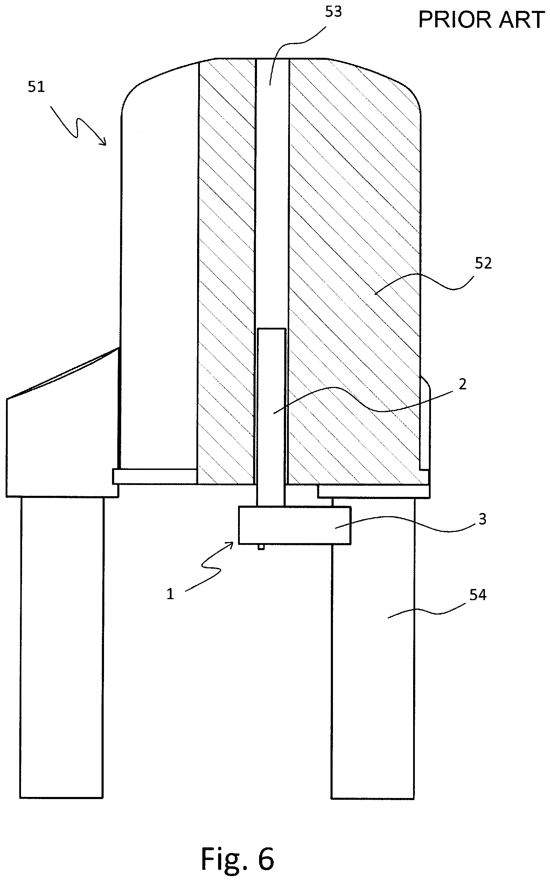

Ein Rotor 21a wird zunächst durch den ersten Abschnitt 10a der Transportleitung nach oben in Richtung Weicheneinrichtung 11 durch einen Gasstrom gefördert. Die **Kappe 22** des Rotors 21a weist dabei nach oben. An dieser Kappe 22 sind Flügelelemente (Schaufelräder) ausgebildet (nicht erkennbar in Fig. 6).

Der Rotor 21a wird durch den von unten angreifenden Gasstrom nach oben in den Sackbohrungsabschnitt 13 gedrückt. Der Gasstrom fließt sodann vom Abschnitt 10a durch die Abzweigung 12 in den zweiten Abschnitt 10b der Transportleitung zum Stator 7. Dieser Gasstrom bläst sodann den Rotor 21b in Richtung des zweiten Abschnitts 10b, d.h. der Rotor 21b verschwenkt mit seinem unteren Bodenende nach rechts und sinkt wieder ab. Schließlich wird der Rotor 21c durch den Gasstrom in Richtung MAS-Stator 7 nach rechts unten in den zweiten Abschnitt 10b und in den Stator 7 hinein gedrückt. Bei diesem Manöver beinhaltet die Transportrichtung eine Umkehrung (Wendemanöver).

Zum Ausschleusen eines Rotors 21c aus dem Stator 7 wird ein umgekehrter Gasstrom angelegt. Dieser drückt den Rotor 21c zunächst vom Stator 7 durch den zweiten Abschnitt 10b in den Sackbohrungsabschnitt 13. Sodann stellt sich ein Gasstrom vom zweiten Abschnitt 10b der Transportleitung durch die Abzweigung 12 in den ersten Abschnitt 10a der Transportleitung ein. Dieser zieht den Rotor 21b in Richtung des ersten Abschnitts 10a und schließlich in diesen hinein, so dass der Rotor 21a durch den ersten Abschnitt 10a der Transportleitung zum Fußkasten zurück gefördert wird. Auch dabei beinhaltet die Transportrichtung eine Umkehrung (Wendemanöver).

Durch die Weicheneinrichtung 11, die vom Fußkasten aus gesehen jenseits (hinter) dem MAS-Stator 7 liegt, kann über das Wendemanöver eine 180°-Kurve in der Transportleitung ersetzt werden, und gleichzeitig ein Zugang zum MAS-Stator 7 von der dem Fußkasten abgewandten Seite durch das zweite Radiallager 9b (in Fig. 5 von oben) eingerichtet werden. Ohne die Weicheneinrichtung 11 müsste der Rotor um eine starke Kurve von wenigstens 180°-54,7° = 125,3° geführt werden, um vom vertikalen ersten Abschnitt 10a der Transportleitung in den um den magischen Winkel geneigten Stator 7 und zurück verbracht werden zu können. Da der mögliche Krümmungsradius einer Transportleitung durch die Abmessungen des Rotors begrenzt wird, bräuchte eine solche starke Kurve viel Raum im Rohr des Probenkopfes. Durch die Vermeidung der starken Kurve kann das Rohr einen geringen Innendurchmesser ID aufweisen, so dass auch in enge Raumtemperaturbohrungen von Magnetanordnungen ein erfindungsgemäßer Probenkopf eingeführt werden kann. In dem in Fig. 5 gezeigten Ausführungsbeispiel ist lediglich eine leichte Kurve von 54,7° im Bereich des zweiten Abschnitts 10b der Transportleitung eingerichtet. Der Außendurchmesser des Rohres kann erfindungsgemäß für übliche Raumtemperaturbohrungen leicht auf 40mm oder 73mm begrenzt werden.

Die **Figur 6** zeigt eine modifizierte **NMR-Apparatur 51,** umfassend eine supraleitende **Magnetanordnung 52** (hier umfassend nicht näher dargestellte, solenoidförmige, supraleitende Magnetspulen) mit einer vertikalen **Raumtemperaturbohrung 53.** Die Magnetanordnung 52 ruht auf robusten **Stützen 54.** In die Raumtemperaturbohrung 53 ist von unten ein erfindungsgemäßer NMR-MAS-Probenkopf 1 (vgl. Fig. 4) eingeführt. Der größte Teil des Rohres 2 des Probenkopfes 1 liegt innerhalb der Raumtemperaturbohrung 53, während der Fußkasten 3 des Probenkopfes 1 außerhalb der Raumtemperaturbohrung 53 unterhalb der Magnetanordnung 52 angeordnet ist.

**Figur 7** schließlich zeigt im schematischen Detailschnitt einen gattungsgemäßen MAS-Stator nach dem Stand der Technik, welcher die eingangs definierten -allerdings eben nicht die spezifisch erfindungsgemäßen-Merkmale aufweist und ein von Hand auf- und abschraubbares **Frontlager 96a** zur Einbringung beziehungsweise Entnahme des Rotors den Raum innerhalb des MAS-Stators 7 zwischen Bodenlager 8 und Frontlager 96a umfasst. Bei aufgeschraubtem Frontlager 96a ist die **Öffnung 96b** stets geschlossen, so dass eine automatisierte Be- und Entladung mit dem Rotor nicht möglich ist. Vielmehr muss dieser stets von Hand eingeführt oder entnommen werden.

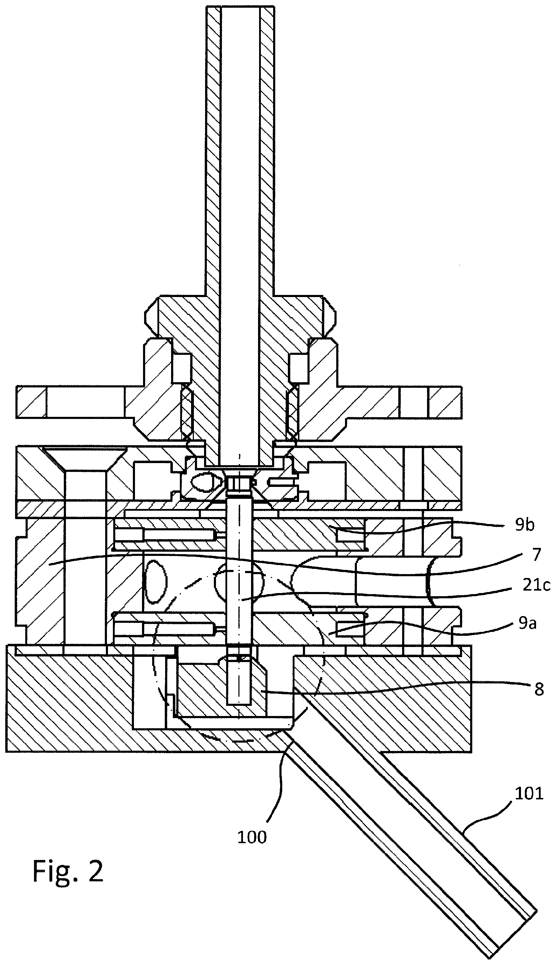

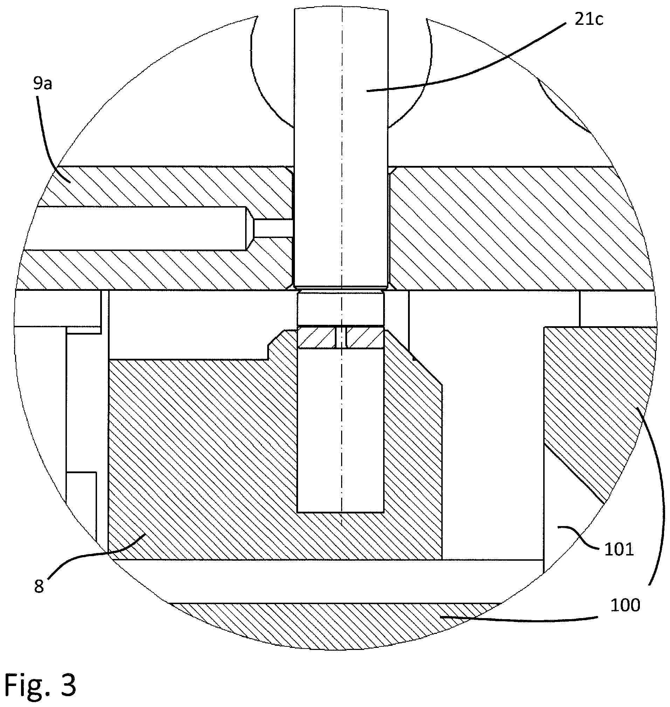

In den **Figuren 1 bis 3** ist eine Ausführungsform des *erfindungsgemäßen* Probenkopfes schematisch in unterschiedlichem Detail dargestellt:

Der gezeigte MAS-Stator 7 weist -wie auch schon der Stator nach dem Stand der Technik- ein Bodenlager 8 mit mindestens einer Düse sowie mindestens ein Radiallager 9a; 9b auf, wobei ein im Wesentlichen kreiszylindrischer MAS-Rotor 21c zur Aufnahme einer Messsubstanz vorgesehen ist, welcher in einer Messposition innerhalb des MAS-Stators 7 mittels einer Einrichtung zur Gaszufuhr druckgasgelagert sowie mittels eines pneumatischen Antriebs in Rotation um die Zylinderachse des MAS-Rotors 21c versetzt werden kann.

Erfindungsgemäß zeichnet sich der in den Figuren 1 bis 3 dargestellte MAS-Stator 7 dadurch aus, dass in einem Raum unterhalb des Radiallagers 9a eine **Absaugvorrichtung 100** zur Absaugung des von der Einrichtung zur Gaszufuhr eingebrachten Gases vorgesehen ist, die so ausgelegt ist, dass sie in dem Raum unterhalb des Radiallagers 9a im Messbetrieb einen Unterdruck gegenüber der den MAS-Stator 7 umgebenden Atmosphäre erzeugen kann.

Der MAS-Stator 7 zur Aufnahme eines MAS-Rotors 21c ist mit einem Durchmesser von 0,2mm bis 2,5mm, vorzugsweise von 0,7mm bis 1,9mm, ausgelegt.

Die Absaugvorrichtung 100 weist eine **Gasleitung 101** auf, die zur Absaugung des von der Einrichtung zur Gaszufuhr eingebrachten Gases dient und einen Querschnitt von 0,2mm² bis 100mm², vorzugsweise von 1,5mm² bis 10mm², haben wird.

Sowohl die Radiallager 9a, 9b als auch das Bodenlager 8 werden bevorzugt über eine gemeinsame Druckgasleitung beschickt. Alternativ können auch mehrere Leitungen verwendet werden. Der Einstrahldruck beträgt 0 bis 5bar relativ zum Umgebungsdruck.

Zum Antrieb der Turbine wird am Kopfende des Rotors 21c ein weiterer Gasstrom auf die Rotorschaufeln gerichtet. Vorzugsweise wird dieser Strom tangential auf die Rotorblätter gerichtet, so dass diese zum Rotieren gebracht werden können. Der Antriebsgasstrom kann bis 5bar relativ zum Umgebungsdruck gehen.

Damit dieses System auch für kleine Rotoren mit Durchmessern ≤ 2,5mm verwendet werden kann, umfasst das System weiterhin eine Absaugleitung am Bodenende des Stators. Die Funktion dieser Leitung ist es, das eingedüste Gas bei reduziertem Relativdruck (ca. -0,1 bis -1 bar) zu entfernen. Im Wesentlichen wird der Gasstrom des Bernoulli-Bodenlagers angesaugt, es werden aber auch Anteile des Gasstroms des unteren Radiallagers nach unten entfernt. Dadurch wird in der Umgebung des Bodenlagers der Gasfluss geändert, sodass eine größere Haltekraft im Bodenlager resultiert.

Optional kann ein weiterer Gasstrom dem Rotor zugeführt werden, der zum gezielten Temperieren der Messprobe dient.
Vorzugsweise umfasst der Stator zwei Radiallager, dies führt zu einer weiteren Stabilisierung des Rotors.
Der Abstand von Radiallager zum Rotor beträgt 5 bis 50µm, vorzugsweise 10 bis 30µm.
Der Abstand von Bodenlager zum Rotor beträgt vorzugsweise 5 bis 25µm.
Der Absaugschlauch sollte einen Innendurchmesser von mindestens 0,5mm aufweisen.

## Patentansprüche

1. MAS-Stator (7) für einen NMR-MAS-Probenkopf (1), wobei der MAS-Stator (7) ein Bodenlager (8) mit mindestens einer Düse sowie mindestens ein Radiallager (9a, 9b) aufweist und ein im Wesentlichen kreiszylindrischer MAS-Rotor (21c) zur Aufnahme einer Messsubstanz vorgesehen ist, welcher in einer Messposition innerhalb des MAS-Stators (7) mittels einer Einrichtung zur Gaszufuhr druckgasgelagert sowie mittels eines pneumatischen Antriebs in Rotation um die Zylinderachse des MAS-Rotors (21c) versetzt werden kann, wobei der MAS-Stator (7) mit einem Absaugrohr ausgestattet ist, **dadurch gekennzeichnet,**
**dass** der MAS-Stator (7) eine Absaugvorrichtung enthält, welche das Absaugrohr umfasst, und welche zur Absaugung des von der Einrichtung zur Gaszufuhr eingebrachten Gases derart eingerichtet ist, dass sie in einem Raum unterhalb des Radiallagers (9a) im Messbetrieb einen Unterdruck gegenüber der den MAS-Stator (7) umgebenden Atmosphäre erzeugt, so dass der Gasstrom des Bodenlagers (8) angesaugt wird und eine größere Haltekraft im Bodenlager (8) resultiert als im Falle ausschließlicher Nutzung des Bernoulli-Effekts, und dass der MAS-Stator (7) zur Aufnahme eines MAS-Rotors (21c) mit einem Durchmesser von 0,2mm bis 2,5mm ausgelegt ist.

2. MAS-Stator nach Anspruch 1, **dadurch gekennzeichnet, dass** der MAS-Stator (7) zur Aufnahme eines MAS-Rotors (21c) mit einem Durchmesser von 0,7mm bis 1,9mm ausgelegt ist.

3. MAS-Stator nach Anspruch 1 oder 2, **dadurch gekennzeichnet, dass** die Absaugvorrichtung (100) eine Gasleitung (101) zur Absaugung des von der Einrichtung zur Gaszufuhr eingebrachten Gases mit einem Querschnitt von 0,2mm² bis 100mm², vorzugsweise von 1,5mm² bis 10mm², aufweist.

4. MAS-Stator nach einem der vorhergehenden Ansprüche, **dadurch gekennzeichnet, dass** die Absaugvorrichtung (100) so ausgelegt ist, dass sie im Messbetrieb mit einem Unterdruck gegenüber der den MAS-Stator (7) umgebenden Atmosphäre von -10⁴ Pa bis -10⁵ Pa (-0,1 bar bis -1 bar) beaufschlagbar ist.

5. MAS-Stator nach einem der vorhergehenden Ansprüche, **dadurch gekennzeichnet, dass** die Düse im Bodenlager (8) einen Innendurchmesser zwischen 25µm und 500µm, vorzugsweise zwischen 80µm und 200µm, aufweist.

6. MAS-Stator nach einem der vorhergehenden Ansprüche, **dadurch gekennzeichnet, dass** die Einrichtung zur Gaszufuhr nur eine einzige Düse im Bodenlager (8) umfasst, mit der im Betrieb sowohl die zur Gaszufuhr für die Druckgaslagerung als auch die Gaszufuhr für den pneumatischen Antrieb zur Rotation des MAS-Rotors (21c) gemeinsam erfolgt.

7. MAS-Stator nach einem der vorhergehenden Ansprüche, **dadurch gekennzeichnet, dass** eine weitere Vorrichtung zur Gaszufuhr zum MAS-Rotor (21c) vorgesehen ist, mit welcher die Messsubstanz im Messbetrieb auf einer vorgebbaren Betriebstemperatur gehalten werden kann.

8. MAS-Stator nach einem der vorhergehenden Ansprüche, **dadurch gekennzeichnet, dass** der MAS-Stator (7) zur Einstellung des MAS-Winkels drehbar gelagert ist.

9. Probenkopf (1) mit einem MAS-Stator (7) nach einem der vorhergehenden Ansprüche, **dadurch gekennzeichnet, dass** ein pneumatisches Probenwechselsystem mit einer Transportleitung (10) zum Zuführen und Abführen eines MAS-Rotors (21a-21c) zum MAS-Stator (7) vorgesehen ist.

10. Probenkopf nach Anspruch 9, **dadurch gekennzeichnet, dass** die Düse im Bodenlager (8) bei ausgeschalteter Absaugvorrichtung (100) ein Bestandteil des pneumatischen Probenwechselsystems ist, mit dem der MAS-Rotor (21c) aus dem MAS-Stator (7) auswerfbar ist.

11. Verfahren zum Betrieb eines Probenkopfes (1) mit einem MAS-Stator (7) nach einem der vorhergehenden Ansprüche, **dadurch gekennzeichnet, dass** der MAS-Stator (7) einen MAS-Rotor (21c) mit einem Durchmesser von 0,2mm bis 2,5mm aufweist, und dass nach Positionieren des MAS-Rotors (21c) im MAS-Stator (7) zunächst die Absaugvorrichtung (100) angefahren wird, bevor das Bodenlager (8) mit Druckgas beschickt wird, sodass der MAS-Rotor (21c) im Stator verbleibt und vibrationsfreier rotieren kann, um eine ausreichend hohe Haltekraft für stabilen Betrieb ohne ungewünschten Auswurf zu erzielen.

12. Verfahren nach Anspruch 11, **dadurch gekennzeichnet, dass** nach erfolgter NMR-Messung der MAS-Rotor (21c) mit der Messsubstanz aus seiner Messposition innerhalb des MAS-Stators (7) entfernt wird, indem die Unterdruckerzeugung an der Absaugvorrichtung (100) abgeschaltet wird, während jedoch die Einrichtung zur Gaszufuhr am Bodenlager (8) mit Druckgas beschickt wird, so dass im Raum unterhalb des Radiallagers (9a) ein Überdruck aufgebaut wird, durch welchen der MAS-Rotor (21c) aus seiner Messposition herausgeworfen wird.

13. Verfahren nach Anspruch 11 oder 12, **dadurch gekennzeichnet, dass** ein MAS-Rotor (21c) mit einem Durchmesser von 0,7mm bis 1,9mm verwendet wird.

## Claims

1. MAS stator (7) for an NMR-MAS probe head (1), wherein the MAS stator (7) comprises a bottom bearing (8) with at least one nozzle and at least one radial bearing (9a, 9b), and one substantially circular cylindrical MAS rotor (21c) is provided for receiving a measurement substance, wherein the MAS rotor can be supported by compressed gas in a measurement position within the MAS stator (7) by means of a gas supply device and can be rotated about the cylinder axis of the MAS rotor (21c) by means of a pneumatic drive, wherein the MAS stator (7) is provided with a suction tube, **characterized in that** the MAS stator (7) contains a suction device comprising the suction tube and being designed for suctioning-off the gas introduced by the gas supply device in such a manner that it generates an underpressure with respect to the atmosphere surrounding the MAS stator (7) in the space below the radial bearing (9a) during measurement operation such that the gas flow of the bottom bearing (8) is drawn by suction, which results in an increase in retaining force in the bottom bearing (8) than in the case of exclusive utilization of the Bernoulli effect, and that the MAS stator (7) is designed to receive an MAS rotor (21c) having a diameter of 0.2mm to 2.5mm.

2. MAS stator according to claim 1, **characterized in that** the MAS stator (7) is designed to receive an MAS rotor (21c) having a diameter of 0.7mm to 1.9mm.

3. MAS stator according to claim 1 or 2, **characterized in that** the suction device (100) has a gas line (101) for suctioning-off the gas introduced by the gas supply device, which has a cross-section of 0.2mm² to 100mm², preferably of 1.5mm² to 10mm².

4. MAS stator according to any one of the preceding claims, **characterized in that** the suction device (100) is designed such that it can be loaded during measurement operation with an underpressure with respect to the atmosphere surrounding the MAS stator (7) of -10⁴ Pa to -10⁵ Pa (-0.1 bar to -1 bar).

5. MAS stator according to any one of the preceding claims, **characterized in that** the nozzle in the bottom bearing (8) has an inner diameter of between 25µm und 500µm, preferably between 80µm and 200µm.

6. MAS stator according to any one of the preceding claims, **characterized in that** the gas supply device comprises only one single nozzle in the bottom bearing (8), that nozzle commonly supplying the gas for the pressure gas bearing as well as the gas for the pneumatic drive for rotation of the MAS (21c) rotor during operation.

7. MAS stator according to any one of the preceding claims, **characterized in that** a further device is provided for supplying gas to the MAS rotor (21c), by means of which the measurement substance can be kept at a predeterminable operating temperature during measurement operation.

8. MAS stator according to any one of the preceding claims, **characterized in that** the MAS stator (7) is disposed to be rotatable for adjusting the MAS angle.

9. Probe head (1) comprising an MAS stator (7) according to any one of the preceding claims, **characterized in that** a pneumatic sample changing system is provided having a transport line (10) for supplying and discharging an MAS rotor (21a-21c) to the MAS stator (7).

10. Probe head according to claim 9, **characterized in that**, when the suction device (100) is switched off, the nozzle in the bottom bearing (8) is a component of the pneumatic sample changing system by means of which the MAS rotor (21c) can be ejected from the MAS stator (7).

11. Method for operating a probe head (1) comprising an MAS stator (7) according to any one of the preceding claims, **characterized in that** the MAS stator (7) comprises an MAS rotor (21c) having a diameter of 0.2mm to 2.5mm, and that after positioning the MAS rotor (21c) in the MAS stator (7), the suction device (100) is initially started before compressed gas is supplied to the bottom bearing (8) such that the MAS rotor (21c) remains in the stator and can rotate in a more vibration-free manner in order to achieve a sufficiently large retaining force for stable operation without undesired ejection.

12. Method according to claim 11, **characterized in that** the MAS rotor (21c) with measuring substance is removed from its measurement position within the MAS stator (7) after termination of the NMR measurement, **in that** underpressure generation of the suction device (100) is switched off, whereas, however, the gas supply device supplies compressed gas to the bottom bearing (8) such that an overpressure is built up in the space below the radial bearing (9a) by means of which the MAS rotor (21c) is ejected out of its measurement position.

13. Method according to claim 11 or 12, **characterized in that** an MAS rotor (21c) is used having a diameter of 0.7mm to 1.9mm.

## Revendications

1. Stator de MAS (7) pour une tête de sonde RMN-MAS (1), lequel stator de MAS (7) présente un palier de fond (8) avec au moins une buse ainsi qu'au moins un palier radial (9a, 9b) et un rotor de MAS (21c) sensiblement cylindrique circulaire destiné à recevoir une substance à mesurer étant prévu, lequel est supporté par gaz comprimé, au moyen d'un dispositif d'alimentation en gaz, dans une position de mesure à l'intérieur du stator de MAS (7) et peut être mis en rotation autour de l'axe de cylindre du rotor de MAS (21c) au moyen d'un entraînement pneumatique, le stator de MAS (7) étant équipé d'un tube d'aspiration,
**caractérisé en ce**
**que** le stator de MAS (7) contient un dispositif d'aspiration qui comprend le tube d'aspiration et qui est conçu pour aspirer le gaz introduit par le dispositif d'alimentation en gaz de façon à produire dans un espace situé sous le palier radial (9a), en mode de mesure, une dépression par rapport à l'atmosphère environnant le stator de MAS (7), de sorte que le flux de gaz du palier de fond (8) est aspiré et qu'il en résulte une plus grande force de maintien dans le palier de fond (8) qu'en cas d'utilisation exclusive de l'effet Bernoulli, et que le stator de MAS (7) est conçu pour recevoir un rotor de MAS (21c) d'un diamètre de 0,2 mm à 2,5 mm.

2. Stator de MAS selon la revendication 1, **caractérisé en ce que** le stator de MAS (7) est conçu pour recevoir un rotor de MAS (21c) d'un diamètre de 0,7 mm à 1,9 mm.

3. Stator de MAS selon la revendication 1 ou 2, **caractérisé en ce que** le dispositif d'aspiration (100) présente une conduite de gaz (101) pour aspirer le gaz introduit par le dispositif d'alimentation en gaz ayant une section transversale de 0,2 mm² à 100 mm², de préférence de 1,5 mm² à 10 mm².

4. Stator de MAS selon l'une des revendications précédentes, **caractérisé en ce que** le dispositif d'aspiration (100) est conçu de façon à pouvoir être soumis, en mode de mesure, à une dépression par rapport à l'atmosphère environnant le stator de MAS (7) de -10⁴ Pa à -10⁵ Pa (-0,1 bar à -1 bar).

5. Stator de MAS selon l'une des revendications précédentes, **caractérisé en ce que** la buse dans le palier de fond (8) présente un diamètre intérieur compris entre 25 µm et 500 µm, de préférence entre 80 µm et 200 µm.

6. Stator de MAS selon l'une des revendications précédentes, **caractérisé en ce que** le dispositif d'alimentation en gaz comprend seulement une seule buse dans le palier de fond (8), avec laquelle sont réalisées ensemble, en fonctionnement, aussi bien l'alimentation en gaz pour le support par gaz comprimé que l'alimentation en gaz pour l'entraînement pneumatique servant à la rotation du rotor de MAS (21c).

7. Stator de MAS selon l'une des revendications précédentes, **caractérisé en ce qu'**un autre dispositif d'alimentation en gaz du rotor de MAS (21c) est prévu, avec lequel la substance à mesurer peut, en mode de mesure, être maintenue à une température de service pouvant être prédéfinie.

8. Stator de MAS selon l'une des revendications précédentes, **caractérisé en ce que** le stator de MAS (7) est monté tournant pour le réglage de l'angle de MAS.

9. Tête de sonde (1) dotée d'un stator de MAS (7) selon l'une des revendications précédentes, **caractérisée en ce qu'**un système pneumatique de changement d'échantillon avec une conduite de transport (10) pour amener et évacuer un rotor de MAS (21a-21c) au stator de MAS (7) est prévu.

10. Tête de sonde selon la revendication 9, **caractérisée en ce que**, lorsque le dispositif d'aspiration (100) est désactivé, la buse dans le palier de fond (8) est un composant du système pneumatique de changement d'échantillon avec lequel le rotor de MAS (21c) peut être éjecté du stator de MAS (7).

11. Procédé de fonctionnement d'une tête de sonde (1) dotée d'un stator de MAS (7) selon l'une des revendications précédentes, **caractérisé en ce que** le stator de MAS (7) présente un rotor de MAS (21c) d'un diamètre de 0,2 mm à 2,5 mm, et qu'après positionnement du rotor de MAS (21c) dans le stator de MAS (7), le dispositif d'aspiration (100) est approché avant que le palier de fond (8) ne soit alimenté en gaz comprimé, de sorte que le rotor de MAS (21c) reste dans le stator et peut tourner avec moins de vibrations afin d'obtenir une force de maintien suffisamment élevée pour un fonctionnement stable sans éjection non désirée.

12. Procédé selon la revendication 11, **caractérisé en ce que** qu'à l'issue d'une mesure de RMN, le rotor de MAS (21c) avec la substance à mesurer est éloigné de sa position de mesure à l'intérieur du stator de MAS (7) en désactivant la production de dépression au dispositif d'aspiration (100), tandis toutefois que le dispositif d'alimentation en gaz au palier de fond (8) est alimenté en gaz comprimé, de sorte qu'une surpression est créée dans l'espace situé sous le palier radial (9a), par laquelle le rotor de MAS (21c) est éjecté de sa position de mesure.

13. Procédé selon la revendication 11 ou 12, **caractérisé en ce qu'**on utilise un rotor de MAS (21c) d'un diamètre de 0,7 mm à 1,9 mm.
